(19) Europäisches Patentamt
European Patent Office
Office européen des brevets

(11) **EP 4 006 787 A1**

(12) **EUROPEAN PATENT APPLICATION**

(43) Date of publication:
**01.06.2022 Bulletin 2022/22**

(21) Application number: **20386054.9**

(22) Date of filing: **25.11.2020**

(51) International Patent Classification (IPC):
**G06N 10/00** (2022.01)   **B82Y 10/00** (2011.01)
**H01L 29/06** (2006.01)   **H01L 29/12** (2006.01)
**H01L 29/423** (2006.01)   **H01L 29/66** (2006.01)

(52) Cooperative Patent Classification (CPC):
**G06N 10/00; H01L 29/0665; H01L 29/122;
H01L 29/423; H01L 29/66977;** B82Y 10/00;
H01L 29/778

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **IST Austria - Institute of Science and
Technology Austria
3400 Klosterneuburg (AT)**

(72) Inventor: **The designation of the inventor has not
yet been filed**

(74) Representative: **J A Kemp LLP
80 Turnmill Street
London EC1M 5QU (GB)**

(54) **QUBIT DEVICE AND METHOD OF OPERATING A QUBIT DEVICE**

(57)   The disclosure relates to a qubit device and to methods of operating a qubit device. In one arrangement, a quantum well structure hosts a hole gas in a quantum well. Electrodes form a plurality of quantum dots in the hole gas and allow encoding of a unit of quantum information in hole spins in the quantum dots. X-rotations on the Bloch sphere can be implemented using a g-factor difference between hole spins and a low applied magnetic field. Z-rotations can be implemented using the exchange interaction.

## Fig. 3

EP 4 006 787 A1

**Description**

The invention relates to a qubit device and to methods of operating a qubit device.

Quantum computers have various well-known advantages over classical computers, including the ability to solve certain classes of mathematical problem with higher efficiency. Quantum computers use quantum bits, commonly referred to as qubits, instead of the classical bits used in a classical computer. A qubit device is a device used to implement a qubit.

A promising approach for implementing a qubit is to encode information in the spin degrees of freedom of multiple electrons trapped in respective quantum dots. However, controlling such multi-electron spin encoding can be challenging, requiring complex high frequency signals and micromagnets. It has proven difficult to achieve practical scalability and high-fidelity fast readout.

It is an object of the present disclosure to provide an improved qubit device that at least partially addresses one or more of the issues described above.

According to an aspect of the invention, there is provided a qubit device, comprising: a quantum well structure configured to host a hole gas in a quantum well; and a plurality of electrodes configured to allow the formation of a plurality of quantum dots in the hole gas and to allow encoding of a unit of quantum information in a plurality of hole spins hosted in the quantum dots.

Thus, a qubit device is provided that is based on encoding a unit of quantum information in a plurality of hole spins rather than electron spins. The inventors have found that this alternative approach allows high manipulation speeds and low dephasing rates to be achieved. The use of holes provides strong spin orbit coupling (SOC), which leads to high manipulation speeds and, due to the low hyperfine interaction, low dephasing rates are expected. In some embodiments, the hole spins are holes in Ge. Holes in Ge have particularly strong spin orbit coupling (SOC). In addition, the SOC together with the low effective mass relax fabrication constraints, and larger quantum dots can be operated as qubits without the need for microstrips and micromagnets.

The inventors have further discovered that qubit devices based on hole spins, in accordance with the present disclosure, can be operated at very low magnetic fields. In particular, the qubit devices can be operated at magnetic fields that are below the critical field for a range of superconductors, including aluminium, which allows integration with circuits that use superconducting elements, such as Josephson parametric amplifiers, superconducting resonators and superconducting quantum interference devices. Such integration facilitates scalability and/or high-fidelity fast readout.

In some embodiments, the quantum well structure comprises a heterostructure of semiconductor layers. This approach allows efficient integration with existing semiconductor manufacturing technologies.

In some embodiments, the quantum information is encoded into singlet and triplet states of the hole spins hosted in the plurality of quantum dots, for example in a double quantum dot (DQD). The inventors have demonstrated particularly efficient operation in this regime, with a Ge hole spin qubit in a DQD device being shown to be operable at very low fields, including below the critical field of aluminium.

In some embodiments, the quantum well structure comprises a quantum well layer comprising more than 90% Ge, preferably isotopically purified Ge. The use of isotopically purified Ge reduces a magnetic noise contribution (due to reduced amounts of Ge isotopes having nuclear spin), allowing additional improvements in qubit coherence and quality.

In some embodiments, the device implements X-rotations on the Bloch sphere of the qubit using the g-factor difference between hole spins and an applied magnetic field, wherein the applied magnetic field is preferably below 100mT (optionally significantly lower, such as below 1 0mT). The inventors have found that extremely high X-rotation speeds and long dephasing times can be achieved in this manner, leading to high manipulation speeds and low dephasing rates. The low magnetic fields facilitate integration with superconducting devices, as mentioned above.

The invention will now be further described, by way of example, with reference to the accompanying drawings, which are summarised below.

Figure 1 is a schematic cross-sectional view of a qubit device according to an embodiment.

Figure 2 is a schematic cross-sectional view of a qubit device according to an alternative embodiment.

Figure 3 is a scanning electron microscope (SEM) image of a gate layout used for implementing a control arrangement for the device of Figure 1 or 2.

Figure 4 depicts a stability diagram for the parameter region of interest. The effective number of holes in each Coulomb blocked island is defined as "$(N_L, N_R)$". The quotes symbolize an equivalent hole number. The quotes are omitted in the description below. The diagonal arrow corresponds to a detuning ($\varepsilon$) axis.

Figure 5 depicts a stability diagram acquired while pulsing in a clockwise manner following the arrows. The system is emptied (E) in (1,0) and pulsed to (1,1) (separation point S) where either a singlet or a triplet will be loaded. Upon pulsing to the measurement point (M) in (2,0), triplet states are blocked leading to the marked triangular blockade region.

Figure 6 (upper graph) depicts an energy dispersion relation as a function of $\varepsilon$ at finite magnetic field. $\varepsilon = 0$ is defined

at the (2, 0) ↔ (1, 1) resonance. At high $\varepsilon$ the Hamiltonian has the four eigenstates: two polarized triplets $|T_-\rangle$ =

$|\downarrow\downarrow\rangle$, $|T_+\rangle = |\uparrow\uparrow\rangle$ and two anti-parallel spin states $|\uparrow\downarrow\rangle$, $|\downarrow\uparrow\rangle$. The triplet Zeeman energy $E_Z^T = \pm \sum g\mu_B B/2$ lifts the degeneracy of the triplets. The singlet energy $E_S = \frac{\epsilon}{2} - \sqrt{\frac{\epsilon^2}{4} + 2t_C^2}$, where $t_C$ is the tunnel coupling between the dots, anti-crosses with the polarized triplet states due to spin-orbit interaction parametrized by $t_{SO}$. The singlet $S_G := S$ and triplet $T_0$ are split in energy by the exchange interaction $J$ which decreases with increasing $\varepsilon$.

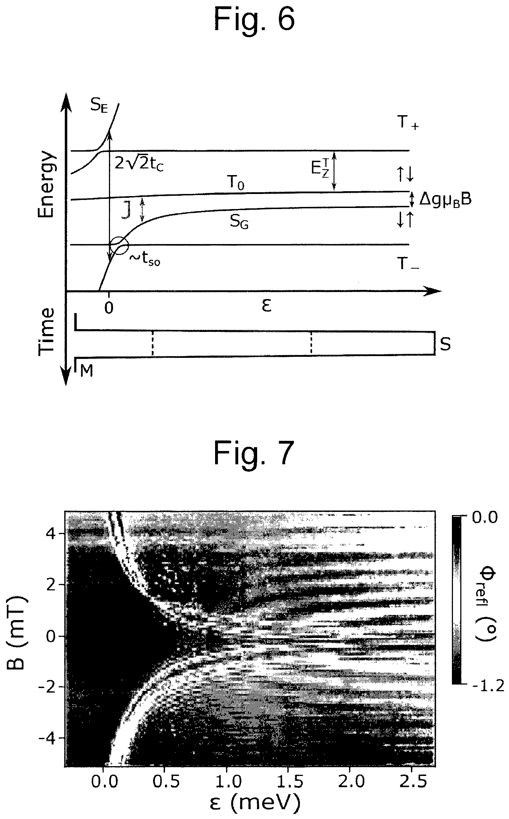

Figure 6 (lower graph) depicts a pulse sequence used to acquire the spin funnel shown in Figure 7. Starting from (2,0) the system is pulsed to (1,1) at varying $\varepsilon$, left evolving for 100 ns and then pulsed back to measure in M.

Figure 7 depicts the results of a spin tunnel experiment confirming the energy dispersion shown in Figure 6 (upper graph) and the validity of assuming an effective hole number of (2,0) and (1,1). When $J(\epsilon) = E_Z^T$ the triplet signal increases as a result of S - T_ intermixing. Around the funnel S - T_ oscillations can be observed while at higher detuning S = $T_0$ oscillations become more prominent.

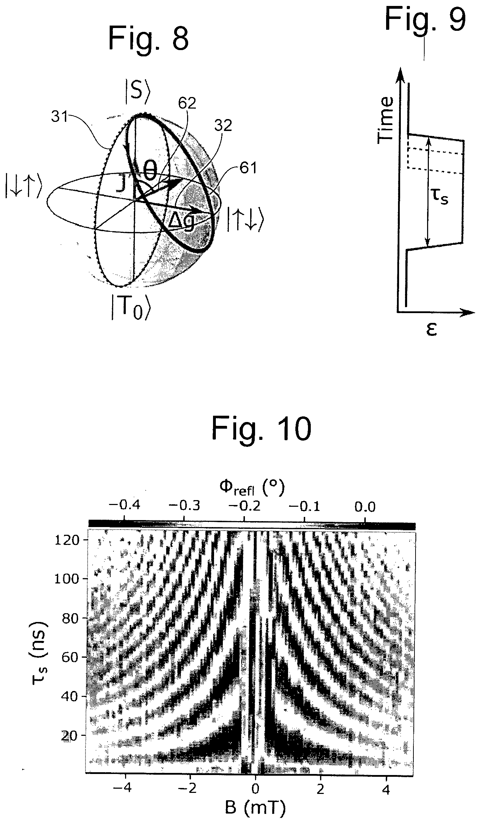

Figure 8 depicts state evolution on the Bloch sphere, with trajectories shown that correspond to a perfect X-rotation and to an effective rotation tilted by an angle $\theta$ from the Z-axis.

Figure 9 depicts example pulse sequences for performing X-rotations.

Figure 10 is a graph depicting observed X-oscillations as a function of $\tau_S$ and B at $V_{CB}$ = 910 mV.

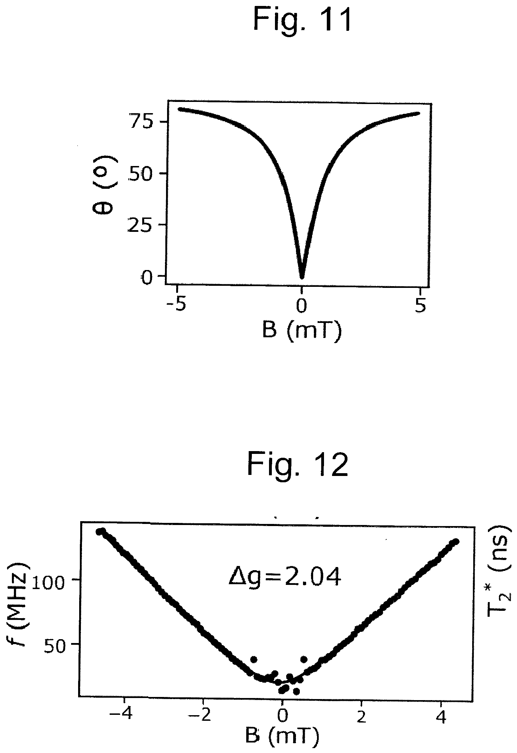

Figure 11 is a graph depicting variation of the angle $\theta$ as a function of B.

Figure 12 is a graph depicting variation of a frequency $f$ of the X-oscillations as a function of B.

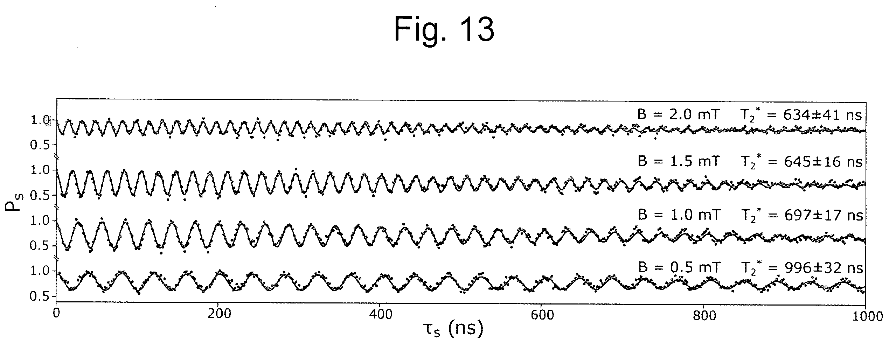

Figure 13 is a graph depicting singlet probabilities $P_S$ as a function of $\tau_S$ for different magnetic fields.

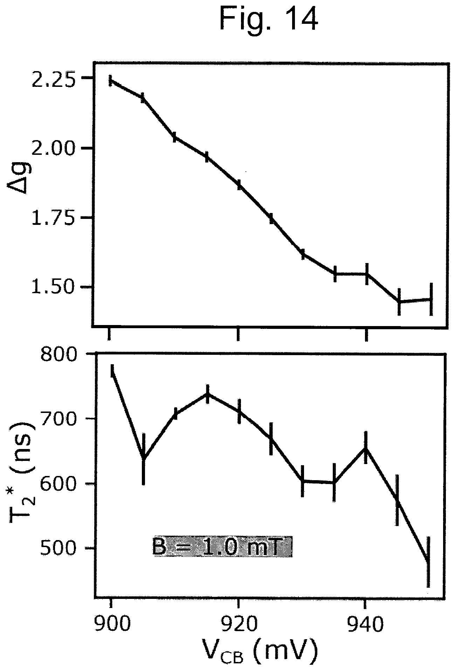

Figure 14 (upper graph) is a graph depicting the g-factor difference $\Delta g$ as a function of $V_{CB}$.

Figure 14 (lower graph) is a graph depicting the variation of the inhomogeneous dephasing time $T_2^*$ as a function of $V_{CB}$.

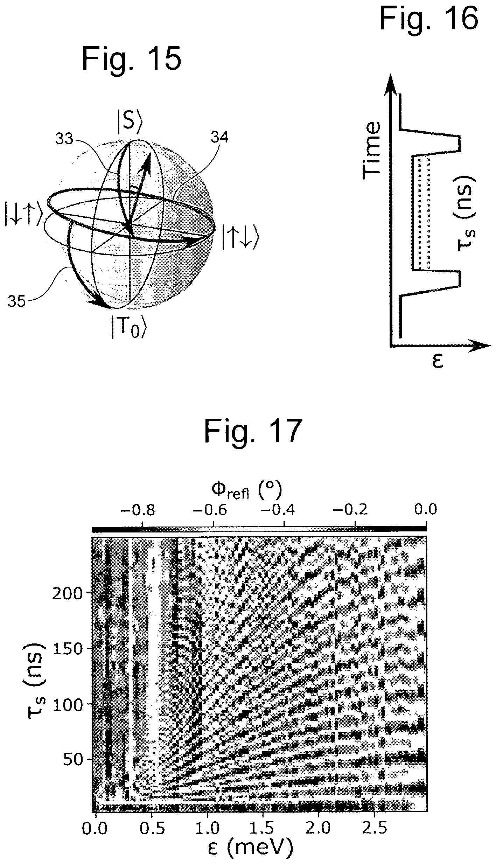

Figure 15 depicts the state evolution on the Bloch sphere, with trajectories showing application of $\frac{\pi_x}{2}$-pulses applied at maximum detuning and subsequent free evolution at smaller $\varepsilon$.

Figure 16 depicts example pulse sequences for probing Z-rotations.

Figure 17 is a graph depicting observed Z-oscillations as a function of $\tau_S$ and $\varepsilon$.

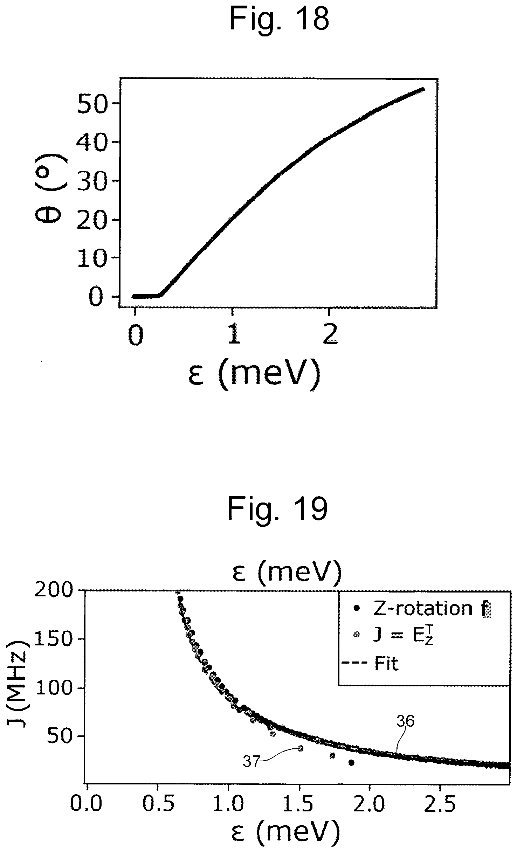

Figure 18 is a graph depicting variation of $\theta$ as a function of $\varepsilon$.

Figure 19 is a graph depicting variation of $J$ as a function of $\varepsilon$.

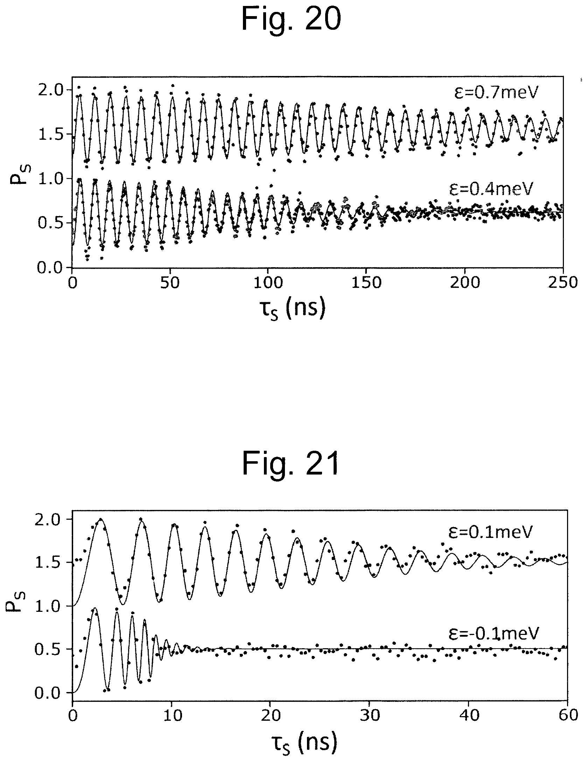

Figures 20 and 21 are the graphs depicting variation of $P_S$ as a function of $\tau_S$ and $\varepsilon$.

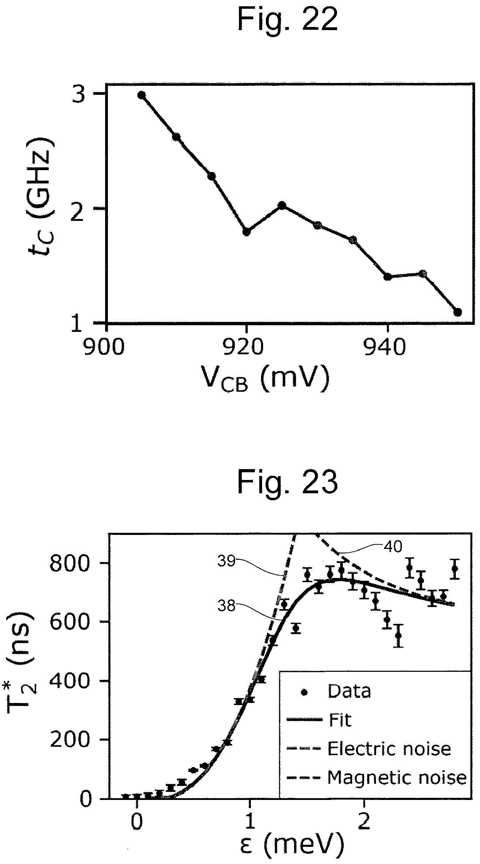

Figure 22 is a graph depicting tunnel coupling $t_C$ as a function of $V_{CB}$ demonstrating good control over the tunnel barrier between the two quantum dots.

Figure 23 is a graph depicting variation of $T_2^*$ as a function of $\varepsilon$.

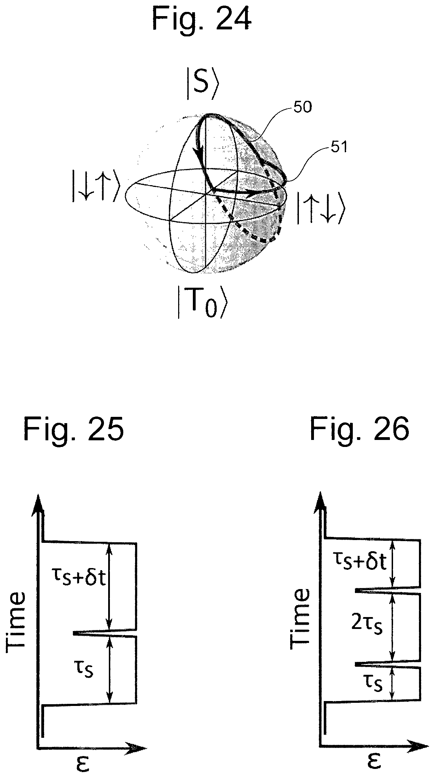

Figure 24 depicts the state evolution on the Bloch sphere, with trajectories showing application of short exchange pulses to implement spin echo technique.

Figures 25 and 26 depict example pulse sequences for one and two refocusing pulses.

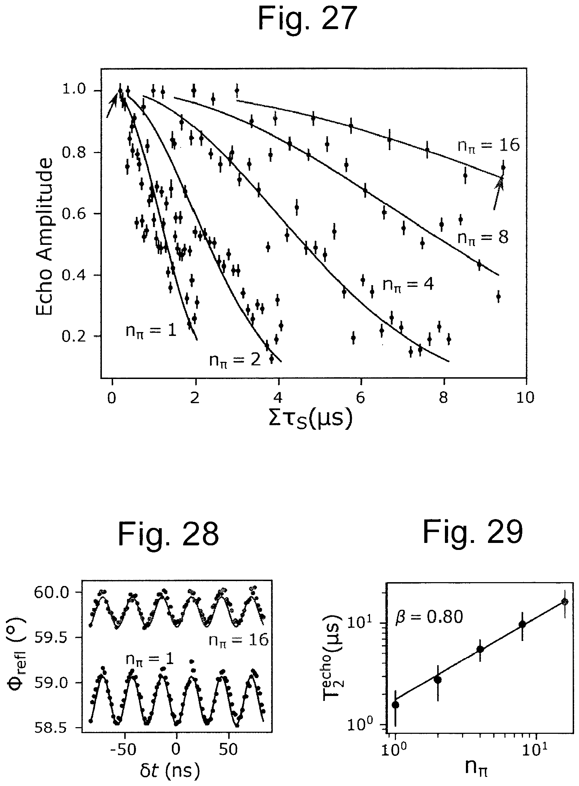

Figure 27 is a graph depicting the normalized echo amplitude as a function of total separation time for different numbers of $\pi$-pulses.

Figure 28 is a graph depicting examples of S-$T_0$ oscillations as a function of $\delta t$ taken for the points highlighted by arrows in Figure 27.

Figure 29 is a graph showing the power law dependence of $T_2^{Echo}$ vs $n_\pi$.

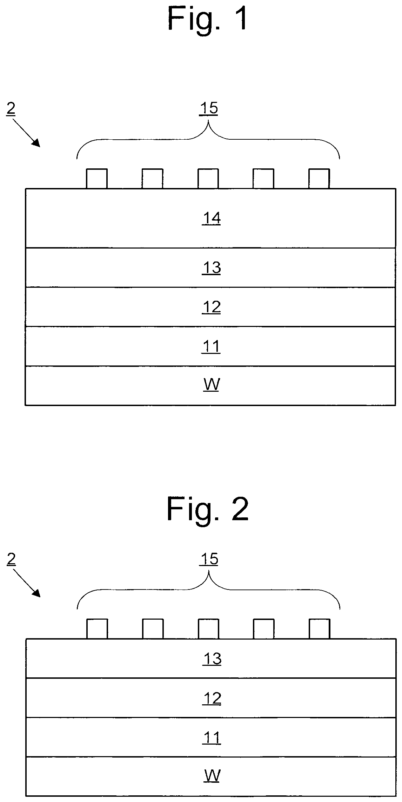

The present disclosure relates to qubit devices. Qubit devices are devices for implementing a quantum bit (commonly referred to as a qubit). In some embodiments, a qubit device comprises a quantum well structure 2 and a plurality of electrodes 15, as exemplified in Figures 1 and 2. The quantum well structure 2 is configured to host a hole gas. In some embodiments, as exemplified in detail below, the hole gas is a two-dimensional hole gas. However, the hole gas could alternatively be a one-dimensional hole gas. The electrodes 15 are configured to allow the formation of a plurality of quantum dots in the hole gas. The electrodes 15 are further configured to allow encoding of a unit of quantum information in a plurality of hole spins in the quantum dots. In some embodiments, the unit of quantum information is encoded into singlet and triplet states of the hole spins hosted in the quantum dots. As exemplified in detail below, the plurality of quantum dots in which the unit of quantum information is encoded may consist of a double quantum dot (i.e. two quantum dots).

The quantum well structure 2 may comprise a quantum well formed within a heterostructure of semiconductor layers. The heterostructure of semiconductor layers may be provided on a substrate W, such as a silicon wafer. In some embodiments, the quantum well structure 2 comprises a quantum well layer 12 sandwiched between two confinement layers. The quantum well layer 12 may comprise a semiconductor with a relatively small bandgap (commonly referred to as a quantum well) and the confinement layers may comprise semiconductors with larger bandgaps. In the examples shown, the two confinement layers comprise a lower confinement layer 11 and an upper confinement layer 13.

The quantum well layer 12 may comprise more than 90% Ge, preferably more than 95% Ge, preferably more than 96% Ge, preferably more than 97% Ge, preferably more than 98% Ge, preferably more than 99% Ge. Preferably, the Ge in the quantum well layer 12 comprises, consists essentially of, or consists of isotopically purified Ge (with reduced amounts of Ge isotope having nuclear spin relative to naturally occurring Ge). Alternatively, the Ge in the quantum well layer 12 may comprise, consist essentially of, or consist of, naturally occurring Ge. The thickness of the quantum well layer 12 may be in the range of 1-50nm, preferably 5-25nm, preferably 10-20nm.

Either or both of the confinement layers 11 and 13 may comprise, consist essentially of, or consist of, SiGe with a Si content in the range of 5-50% and a Ge content in the range of 95-50%. Preferably, the Si content is in the range of 5-40%, even more preferably in the range of 20-40%. In embodiments of this type, the quantum well structure 2 may comprise an oxide support layer 14 for supporting the electrodes 15, as exemplified in Figure 1. Either or both of the confinement layers 11 and 13 may have a thickness in the range of 10-200nm, preferably 10-100nm, preferably 20-60nm.

In an alternative approach, as exemplified in Figure 2, the quantum well structure 2 may be formed using Ge on insulator technology. In an embodiment of this type, either or both of the confinement layers may comprise an oxide layer. For example, the lower confinement layer 11 may comprise $SiO_2$ and the upper confinement layer 13 may comprise any oxide suitable for supporting the electrodes 15. The upper confinement layer 13 of the embodiment of Figure 2 might be the same oxide layer as oxide support layer 14 of the embodiment of Figure 1. The upper confinement layer 13 of Figure 2 and/or the oxide support layer 14 of Figure 1 preferably has a thickness in the range of 5-50nm, preferably 5-35nm. The upper confinement layer 13 of Figure 2 and/or the oxide support layer 14 of Figure 1 may comprise, consist essentially of, or consist of, one or more of the following, optionally formed by atomic layer deposition: aluminium oxide, hafnium oxide, zirconium oxide (or any other high dielectric constant oxide). The layer may be grown for example at a temperature between 50-300C using atomic layer deposition.

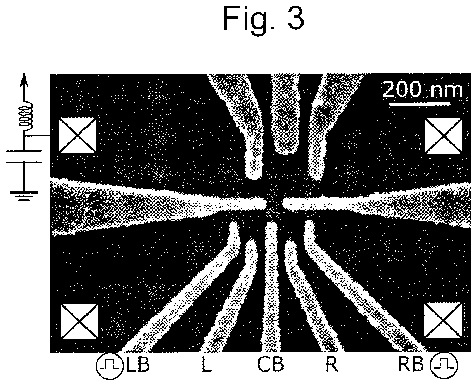

The electrodes 15 may comprise a plurality of gates. The electrodes 15 may be metallic. The gates may be configured to operate in a depletion mode, in which case they may be referred to as depletion gates. Alternatively, the gates may be configured to operate in an accumulation mode, in which case they may be referred to as accumulation gates. An example arrangement for the electrodes 15 (gates) is described below with reference to Figure 3. A first quantum dot is formed between gates LB and CB and a second quantum dot is formed between gates CB and RB. The lower gates (LB, L, CB, R, RB) thus form a double quantum dot (DQD) system. The upper gates tune a charge sensor (CS) dot. The separation gates in the middle are tuned to maximize the CS sensitivity to charge transitions in the DQD. An LC-circuit connected to a CS ohmic contact allows fast read-out through microwave reflectometry. LB and RB are further connected to fast gate lines enabling fast control of the energy levels in the DQD.

Thus, a quantum well is used to form the qubit by using gate electrodes to create quantum dots in the quantum well. Holes are localized in these quantum dots. The spin of the localized holes is used to encode the quantum information of the qubit. To operate the qubit, it is necessary to send appropriate electrical signals to the gate electrodes and to use a magnetic field.

The qubit can be read out (i.e. the unit of quantum information encoded in the hole spins of the double quantum dot can be read out, in the example shown) in various ways. In the example described below, the qubit is read out via charge sensing using a nearby quantum dot (the upper three terminals in Figure 3). Alternatively, a quantum point contact could be used for the charge sensing. Alternatively, the qubit can be read out by dispersive read out (reflectometry with lumped elements or using a superconducting resonator). The read out may use the Paulispin blockade (PSB) phenomenon, which effectively provides a type of spin to charge conversion that allows the spin state of the qubit to be probed.

The qubit may be operated by performing rotations about two axes on the Bloch sphere of the qubit. This allows access to any point on the Bloch sphere, which is useful for quantum computation. In embodiments of the present disclosure, X and Z rotations are implemented. The X and Z rotations allow access to the full Bloch sphere.

In some embodiments, the device is configured to implement X-rotations on the Bloch sphere of the qubit using a g-factor difference between the hole spins in the quantum dots (e.g. in a double quantum dot) upon application of a small magnetic field. In some embodiments, the qubit is initialized in one state (e.g. a singlet state) and an electrical pulse is applied using the electrodes. The consequence of this electrical pulse is that the state is not any more an eigenstate (if the hole g-factors in the quantum dots are different). As a consequence, oscillations occur, which if the exchange interaction is sufficiently low can be about the X axis (or an axis near to the X-axis. The X-rotations correspond to oscillations between the singlet and triplet $T_0$ states. The magnetic field may be below 100mT, preferably below 50mT, preferably below 25mT, preferably below 10mT (as achieved in the examples discussed below). The device may thus be configured to apply electrical signals to the electrodes 15 and to apply a magnetic field to the quantum well structure 2. The device may thus comprise any suitable electrical equipment for providing these functionalities (e.g. power sources, circuit equipment, magnets, etc.). In some embodiments, the magnetic field is provided using a superconducting magnet or a permanent magnet. Alternatively, the magnetic field can be created with a ferromagnetic insulator (such as EuS) or a micromagnet made out of Ni, Co or Fe for example. The magnetic field can point at any orientation. The X-rotation frequency can be electrically tuned by making use of the tunability of hole g-factors.

Z-rotations on the Bloch sphere can be implemented by making use of the exchange interaction, i.e. wavefunction overlap between the quantum dots. Z-rotations may thus be switched on by allowing wavefunction overlap between the quantum dots. For example, the qubit may be initialized in one state (e.g. a singlet state). The electrodes may then be used to apply an electrical pulse that brings the qubit system close to the equator of the Bloch sphere and, subsequently, the electrodes may be used to increase the exchange interaction (by increasing wavefunction overlap, for example by lowering the tunnel barrier potential) to cause rotation about the Z axis (or about an axis near to the Z axis).

Qubits according to the present disclosure could be integrated with Ge gatemon qubits (based on Ge Josephson junctions) implemented in the same heterostructure as well as with superconducting resonators fabricated out of Al, Nb or granular Al and Josephson parametric amplifiers.

The qubit will typically be operated at very low temperatures. In the example described below, the qubit was measured at around 20mK. It may be possible to measure the qubit at higher temperatures, for example in the range of 10mK to 4K.

### EXAMPLE

An exemplary embodiment is described in further detail below. In this example, the qubit device uses Ge hole spins in a double quantum dot (DQD).

The quantum well structure 2 was provided as a strained SiGe\Ge\SiGe heterostructure grown by low-energy plasma-enhanced chemical vapor deposition (LEP- ECVD). Holes confined in a quantum well of this example are of heavy-hole (HH) type because compressive strain and confinement move light-holes (LHs) to higher energies. The related Kramers doublet of the spin $S_z = \pm 3/2$ states therefore resembles an effective spin-1/2 system, $|\uparrow>$ and $|\downarrow>$.

Figure 3 is a scanning electron microscope (SEM) image of a gate layout used for implementing the control arrangement of this example. Single layer devices can be fabricated because without the application of any negative accumulation voltage a charge carrier density of $9.7 \times 10^{11} cm^{-2}$ was measured. Secondary Ion Mass Spectrometry (SIMS) analysis rules out boron doping in the region of the QW as a source of this carrier density. Without wishing to be bound by theory, it is believed that the high carrier density arises due to the p-type background doping of the Si wafer on which the quantum well structure was formed or due to the existing dislocations and vacancies, in combination with fixed negative charges in the deposited gate oxide.

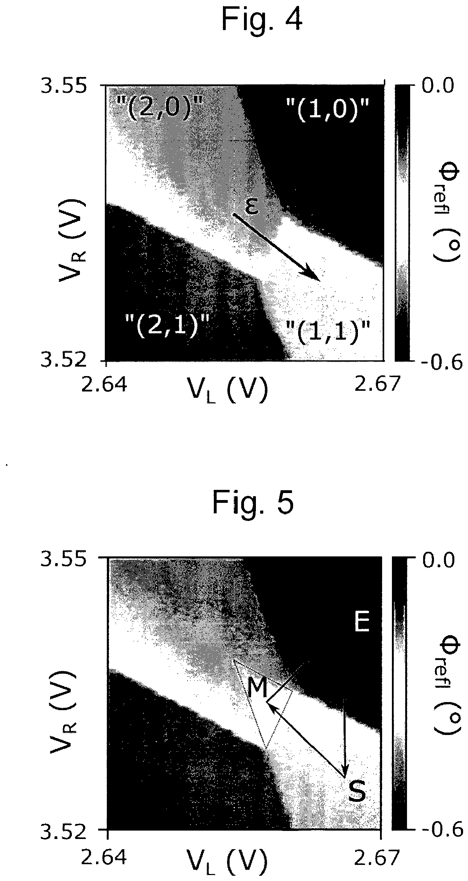

In a singlet-triplet qubit the logical quantum states are defined in a 2-spin 1/2 system with total spin along the quantization axis $S_z = 0$. This can be achieved by confining one spin in each of two tunnel coupled quantum dots. In the present example, the two tunnel coupled quantum dots are formed by depletion gates as depicted in Figure 3. The device can be tuned in the single hole transport regime, as shown by the stability diagrams in Figures 4 and 5, where the sensor dot reflected phase signal ($\phi_{refl}$) is displayed as a function of the voltage on L and R gates shown in Figure 3.

Each Coulomb blocked region corresponds to a fixed hole occupancy, and is labelled by $(N_L, N_R)$, with $N_L(N_R)$ being the number of holes in the left (right) quantum dot. Interdot and dot-lead charge transitions appear as steep changes in the sensor signal. It is possible to deplete the left quantum dot completely while still observing charge transitions at the highest possible voltage on R. Therefore, a precise determination of the hole number in the right dot is not possible.

By pulsing in a clockwise manner along the E-S-M vertices (see Figure 5) a triangular region leaking inside the upper-left Coulomb blocked region is observed. Such feature identifies the metastable region where Pauli spin blockade (PSB) occurs: once initialized in E ('empty'), the pulse to S loads a charge and the spins are separated forming either a spin singlet or a triplet. At the measurement point M within the marked triangle, the spin singlet state leads to tunnel events, while the triplet states remain blocked, which allows spin-to-charge conversion. If the pulsing is performed with a counter-clockwise ordering (E-M-S), no metastable region is observed, as expected (Figure 4 was acquired while pulsing in the counter-clockwise ordering). It is thus considered that the interdot line across the detuning ($\varepsilon$) axis of Figure 4 is equivalent to the $(2,0) \leftrightarrow (1,1)$ effective charge transitions. The system can be tuned along the detuning axis from $(2,0)$ to $(1,1)$ by appropriately pulsing on the LB and RB terminals shown in Figure 3.

A DQD spectrum for a finite B field is shown in Figure 6 (upper graph). The triplet states T(2,0) lie high up in energy and are not shown. The inventors set $\varepsilon = 0$ at the (2,0) $\leftrightarrow$ (1,1) crossing. Starting from (2,0) increasing $\varepsilon$ mixes (2,0) and (1,1) into two molecular singlets, the ground state $S_G := S$ and the excited state $S_E$, which is neglected in the following. The two molecular singlets are split at resonance by the tunnel coupling $2\sqrt{2}t_C$. The triplets are almost unaffected. The exchange energy $J$ is defined as the energy difference between $5 = \frac{1}{\sqrt{2}}(|\uparrow\downarrow\rangle - |\downarrow\uparrow\rangle)$ and the unpolarized triplet $T_0 = \frac{1}{\sqrt{2}}(|\uparrow\downarrow\rangle + |\downarrow\uparrow\rangle)$. At deep positive detuning $J$ drops due to the decrease of the wavefunction overlap for the two separated holes. Importantly, different g-factors for the left ($g_L$) and the right dot ($g_R$) result in four (1,1) states: two polarized triplets $|T_-\rangle = |\downarrow\downarrow\rangle$, $|T_+\rangle = |\uparrow\uparrow\rangle$ and two anti-parallel spin states $|\uparrow\downarrow\rangle$, $|\downarrow\uparrow\rangle$ split by $\Delta E_Z = Ag\mu_B B$, where $\Delta g = |g_L - g_R|$, $\mu_B$ is the Bohr magneton and $B$ is the magnetic field applied in the out-of-plane direction. Even at large positive $\varepsilon$ a residual $J$ can be measured, which leads to the total energy splitting between $|\uparrow\downarrow\rangle$ and $|\downarrow\uparrow\rangle$ being $E_{tot} = \sqrt{J(\epsilon)^2 + (\Delta g \mu_B B)^2}$. A funnel experiment maps out the degeneracy between $J(\varepsilon)$ and $E_Z^T = \pm\frac{\Sigma g \mu_B B}{2}$, where $E_Z^T$ is the Zeeman energy of the polarized triplets and $\Sigma g = g_L + g_R$. By applying a pulse with varying $\varepsilon$ (lower graph of Figure 6) and stepping the magnetic field the plot in Figure 7 is obtained. A doubling of the degeneracy point can be attributed to fast spin-orbit induced $S$ - $T_-$ oscillations. At larger detuning $S$ - $T_0$ oscillations become visible.

The effective Hamiltonian of the qubit subsystem is

$$H = \begin{pmatrix} -J(\epsilon) & \dfrac{\Delta g \mu_B B}{2} \\ \dfrac{\Delta g \mu_B B}{2} & 0 \end{pmatrix} \qquad\qquad (1)$$

in the $\{|S\rangle, |T\rangle\}$ basis, with $J(\varepsilon)$ being the detuning-dependent exchange energy, common to all $S$ - $T_0$ qubits. Here the $S$ - $T_0$ coupling can be controlled both directly via the magnetic field and by electric fields affecting the g-factors. Pulsing on $\varepsilon$ influences $J$ and the ratio between $J$ and $\Delta g \mu_B B$ determines the rotation axis tilted by an angle $\theta = \arctan\left(\frac{\Delta g \mu_B B}{J(\epsilon)}\right)$ from the Z-axis of the Bloch sphere. For large detuning $\theta \to 90°$, which corresponds to X-rotations. For small detuning $\theta \to 0°$, which corresponds to Z-rotations.

A demonstration of coherent X-rotations performed by the inventors is described below with reference to Figures 8-14.

State evolution on the Bloch sphere is depicted in Figure 8. The dashed trajectory 31 corresponds to a perfect X-rotation while the effective rotation axis is tilted by an angle $\theta$ from the Z-axis due to a finite residual $J$ (indicated by an arrow pointing along the Z-axis). X-rotations are controlled by $\Delta g$ and magnetic field and the resulting rotation axis is indicated by arrow 32. The real trajectory and rotation axis are indicated respectively by labels 61 and 62.

In the present example, a center barrier voltage of $V_{CB} = 910$mV is applied with a pulse sequence as depicted in Figure 9 (varying separation time $\tau_S$ with amplitude $\varepsilon = 2.8$ meV). The system is first initialized in (2,0) in a singlet, then pulsed quickly deep into (1,1) where the holes are separated. Here the state evolves in a plane tilted by $\theta$ as depicted in Figure 8. Variation of the angle $\theta$ as a function of magnetic field B, given by $\theta = \arctan\frac{J(2.8meV)}{\Delta g \mu_B B}$, is shown in Figure 11. The effective oscillation axis is thus magnetic field dependent and approaches 80° for $B = 5$ mT. After a separation time $\tau_S$ the system is brought quickly to the measurement point in (2,0) where PSB enables the distinction of triplet and singlet. Varying $\tau_S$ produces sinusoidal X-oscillations (observed as oscillations in $\Phi_{refl}$ as a function of $\tau_S$ for fixed magnetic field B) with frequency $f = \frac{1}{h}\sqrt{J^2 + (\Delta g \mu_B B)^2}$, as shown in Figure 10. The average of each column has been subtracted to account for variations in the reflectometry signal caused by magnetic field. A low (high) signal corresponds to a higher singlet (triplet) probability. Each point is integrated for 100 ms under continuous pulsing.

The variation of the frequency $f$ as a function of magnetic field B is depicted in Figure 12. The black line is a fit to $f$ = from which a g-factor difference $\Delta g = 2.04 \pm 0.04$ and a residual exchange interaction $J(\varepsilon = 2.8\text{meV}) = 21 \pm 1\text{MHz}$ are extracted. Frequencies of 100 MHz are observed at fields as low as 3mT.

Figure 13 shows the extracted singlet probability $P_S$ as a function of $\tau_S$ at different B-fields for $V_{CB} = 910$ mV, extracted through averaged single shot measurements. The black solid line for each magnetic field is a fit to

$$P_S = A\cos(2\pi f \tau_S + \phi)\exp\left(-\left(\frac{t}{T_2^*}\right)^2\right) + C,$$

where $T_2^*$ is the inhomogeneous dephasing time. $P_S$ oscillates only between 0.5 and 1 as a consequence of $J(\varepsilon = 2.8\text{meV}) \neq 0$ and the tilted rotation axis. One would expect an increase in the oscillation amplitude with higher magnetic field. However, at large $\Delta E_Z$ the $T_0$ state quickly decays to the singlet during readout, reducing the visibility as is clearly shown by the curve at 2 mT in Figure 13. This could be circumvented by different read-out schemes such as latching or shelving. A dependence of $\Delta g$ on the voltage on CB, $V_{CB}$, is also observed, as shown in Figure 14 (upper graph), confirming electrical control over the g-factors. As the voltage is decreased by 50 mV, $\Delta g$ varies from $\approx 1.5$ to more than 2.2 which conversely increases the frequency of X-rotations. Concurrently we measure a similar trend in $T_2^*$ reported at $B = 1\text{mT}$ in the lower graph in Figure 14. As the center barrier is lowered the coherence of the qubit is enhanced. The origin and consequences of this observation are discussed below.

A demonstration of Z-rotations performed by the inventors is described below with reference to Figures 15-23.

Z-rotations are achieved by leveraging the exchange interaction and are performed at $B = 1$ mT and $V_{CB} = 910$ mV. State evolution on the Bloch sphere is depicted in Figure 15. The pulse sequence used to perform Z-rotations is depicted in Figure 16. The pulse sequence is such that after initialization in a singlet the system is pulsed to maximum detuning but is maintained in this position only for $t = t_{\pi/2}$ corresponding to a $\pi_x/2$ rotation (indicated by arrow 33 in Figure 15), bringing the system close to $|\uparrow\downarrow\rangle$ (i.e. close to the equator of the Bloch sphere). Now we let the state evolve for a time $\tau_S$ at a smaller detuning (indicated by trajectory 34), increasing $J$ and changing the rotation angle $\theta$, before applying another $\pi_x/2$ rotation (indicated by arrow 35 in Figure 15) at high detuning and pulsing back to read-out. The state evolution on the Bloch sphere in Figure 15 shows that full access to the qubit space can be obtained by a combination of appropriately timed pulses. The resulting oscillation pattern is depicted in Figure 17. From the inferred frequency we find the dependence of $J$ on $\varepsilon$ and extract $t_c/h = 1.86\text{GHz}$ as a free fitting parameter. $J$ as a function of $\varepsilon$ is given by

$$J = \sqrt{f(\epsilon)^2 - \left(\frac{\Delta g \mu_B B}{h}\right)^2}$$

and can be obtained by extracting the oscillation frequency from Figure 17. The extracted values of $J$ are plotted in Figure 19 with the darker markers 36 obtained from the exchange oscillation frequency. The

$$J(\epsilon) = E_Z^T = \frac{\Sigma g \mu_B B}{2}$$

lighter markers 37, on the other hand, correspond to extracted from the funnel experiment (Figure 7). The inventors found that the two sets of data points coincide when $\Sigma g = 11.0$. The fit line is the best fit to

$$J(\epsilon) = \left|\frac{\epsilon}{2} - \sqrt{\frac{\epsilon^2}{4} + 2t_c^2}\right|.$$

Together with the g-factor difference already reported the two out-of-plane g-factors are found to be 4.5 and 6.5. In Figure 20 and 21, $P_S$ is plotted as a function of separation time $\tau_S$ at different values of $\varepsilon$ (with +1 offset for clarity). $P_S$ now oscillates between 0 and 1 due to the combination of $\pi/2$-pulses and free evolution time at lower detuning. From the fits (black solid lines) at different detunings $T_2^*$ as a function of $\varepsilon$ is extracted (Figure 23). For low $\varepsilon$ the coherence time is very short, while it increases for larger $\varepsilon$ and saturates at around 2 meV. This can be explained by a simple noise model where $T_2^*$ depends on electric noise on $J$ and magnetic noise affecting $\Delta E_Z$:

$$\frac{1}{T_2^*} = \frac{\pi\sqrt{2}}{h}\sqrt{\left(\frac{J(\epsilon)}{E_{tot}}\frac{dJ}{d\epsilon}\delta\epsilon_{rms}\right)^2 + \left(\frac{\Delta E_Z}{E_{tot}}\delta\Delta E_{Z\,rms}\right)^2} \qquad (2)$$

where $\delta\varepsilon_{rms}$ is the rms noise on detuning, $\delta\Delta E_{Z_{rms}}$ is the magnetic noise. It is assumed that $\dfrac{d\Delta E_Z}{d\epsilon} \approx 0$ as almost no change in $\Delta g$ with detuning is observed. From the fit (dark line 38) it is found that $\delta\varepsilon_{rms}$ = 7.59 ± 0.35μeV, and $\delta\Delta E_{Z_{rms}}$ = 1.78 ± 0.01neV (smaller by a factor of 2 than in a comparable natural Si qubit). Although $\delta\Delta E_{Z_{rms}}$ is much smaller than

$\delta\varepsilon_{rms}$ it is found that coherence at large detuning is still limited by magnetic noise because $\dfrac{dJ}{d\epsilon} \to 0$ (see broken lines 39 and 40 in Figure 23). For low detuning clearly charge noise is limiting, while at large detuning magnetic noise becomes dominant. It is believed that the magnetic noise is due to randomly fluctuating hyperfine fields caused by spin-carrying isotopes in natural Ge. Eq. 2 gives also insight into the trends observed in Figures 13 and 14 (lower graph). With *B* we now affect $\Delta E_Z$ and, thereby, the ratio to the total energy. The higher this ratio the more the coherence is limited by magnetic noise as confirmed by the drop in $T_2^*$ with magnetic field in Figure 13. Similarly one would expect that by

increasing $\Delta g$, $T_2^*$ should be lower. But, as shown in Figure 22, the raising g-factor difference is accompanied by an increase of the tunnel coupling by 2 GHz. Hence, *J* is larger at lower $V_{CB}$ and $\dfrac{\Delta E_Z}{E_{tot}}$ is reduced leading to a longer $T_2^*$. While $V_{CB}$ affects both $t_C$ and $\Delta g$, we see that $V_{LB}$ and $V_{RB}$ affect mostly $T_C$ and leave $\Delta g$ unaltered. This exceptional tunability enables electrical engineering of the potential landscape to favor fast operations without negatively affecting the coherence times, thus enhancing the quality factor of this qubit. While the longest $T_2^*$ reported here is already comparable to electron singlet-triplet qubits in natural Si, a reduction in the magnetic noise contribution by isotopic purification will further improve qubit coherence and quality.

It is now explained with reference to Figures 24-29 how the coherence of the qubit can be extended by applying refocusing pulses similar to those developed in nuclear magnetic resonance (NMR) experiments. The discussion focusses on the high $\varepsilon$ region where charge noise is lowest.

Figure 24 depicts state evolution on the Bloch sphere. The state evolves on the trajectory 50. At appropriate times, a short exchange pulse is applied (at $\varepsilon$ = 0.4meV in the example shown), which causes the state to follow the trajectory 51. The exchange pulse may be referred to as a refocusing pulse. The state again evolves on the trajectory 50 after the trajectory 51. To obtain a perfect correcting pulse, it would be necessary to implement a more complex pulse scheme. In the present example, convenient $\tau_S$ values $\left( \tau_S = \left(2n + \dfrac{1}{2}\right) t_{\pi_x} \right)$ are chosen such that, if no decoherence has occurred, the system will always be found in the same state after $\tau_S$. The refocusing pulse is then calibrated to apply a $\pi$-pulse that brings the state on the same trajectory (i.e. the trajectory 50) as before the refocusing pulse. $t_{\pi_x}$ is the time needed for a $\pi$-rotation along the trajectory 50. The free evolution time after the last refocusing pulse $\tau_{S'}$ is varied in length from $\tau_S - \delta t$ to $\tau_S + \delta t$ as depicted in Figures 25 and 26 (for one and two refocussing pulses respectively). Figure 27 depicts the normalized echo amplitude as a function of total separation time for the resulting oscillations. Solid lines are a fit to $A_E \exp\left(-t/T_2^{Echo}\right)$ with $A_E$ being the normalized echo amplitude. By increasing the number of $\pi$-pulses

from 1 to 16 the coherence time increases accordingly from $T_2^{Echo}(n_\pi = 1) = 1.8 \pm 0.7\mu s$ to

$T_2^{Echo}(n_\pi = 16) = 16.4 \pm$ 0.4μs. Increasing the number of applied pulses increases the total free evolution time of the qubit. A Carr-Purcell-Meiboom-Gill echo was performed. Furthermore, a power law dependence of $T_2^{Echo}$ is observed as a function of the number of refocusing pulses and $T_2^{Echo} \approx n_\pi^\beta$ with $\beta$ = 0.8 is found. This number is similar to other reported studies in $S - T_0$ qubits in GaAs suggesting that either the materials or the type of qubit have a similar noise spectral density. Refocusing pulses exploiting the symmetric exchange operation could help increasing

$T_2^{Echo}$ further since they are carried out at a charge noise sweet spot.

The inventors have thus shown coherent 2-axis control of a hole singlet-triplet qubit in Ge with dephasing times of 1 μs at 0.5 mT. In most of the so far reported singlet-triplet qubits, X-oscillations were driven by magnetic field differences generated either by nuclear spins or by fabricated micromagnets. Here the inventors have taken advantage of an intrinsic property of heavy hole states in Ge, namely their large and electrically tunable g-factors. They have shown electrically driven X-rotation frequencies approaching 150 MHz at fields of 5mT, which are larger than most of the reported hole spin qubit Rabi frequencies. A $T_2^*$ was observed that exceeds those found in GaAs $S$ - $T_0$ qubits, owing to a lower magnetic noise contribution, while being comparable to values reported for natural Si. This indicates that, although holes in Ge are to first order insensitive to hyperfine interaction, the spin-carrying isotopes might still limit the coherence of the qubit. Most strikingly, by tuning $V_{CB}$ it was found possible to increase the X-rotation frequency by a factor of 1.5 while nearly doubling the inhomogeneous dephasing time of the qubit. Without wishing to be bound by theory, it is believed this observation arises due to electric tunability of the hole g-factors in combination with optimized ratios of electric and magnetic noise contributions. Latched or shelved read-out could circumvent the decay of $T_0$ to $S$ during read-out opening the exploration of the qubit's behavior at slightly higher magnetic fields where the X-rotation frequencies could surpass the highest electron-dipole spin-resonance (EDSR) Rabi frequencies reported so far, without suffering from reduced dephasing times. Furthermore, by moving towards symmetric operation or resonant driving the quality of exchange oscillations can be increased since the qubit is operated at an optimal working point. The long coherence times combined with fast and simple operations at extremely low magnetic fields make this qubit an optimal candidate for integration into a large scale quantum processor.

The samples were processed in the IST Austria Nanofabrication Facility. A $6 \times 6$ mm² chip was cut out from a 4 inch wafer and cleaned before further processing. The Ohmic contacts were first patterned in a 100 keV electron beam lithography system, then a few nm of native oxide and the SiGe spacer were milled down by argon bombardment and subsequently a layer of 60 nm Pt was deposited in situ under an angle of 5°, to obtain reproducible contacts. No additional intentional annealing was performed. A mesa of 90 nm was etched in a reactive ion etching step. The native SiO₂ was removed by a 10s dip in buffered HF before the gate oxide was deposited. The oxide is a 20 nm ALD grown aluminium oxide (Al₂O₃) grown at 300°C, which unintentionally anneals the Ohmic contacts resulting in a low resistance contact to the carriers in the quantum well. The top gates were first patterned via e-beam lithography and then a Ti/Pd 3/27 nm layer was deposited in an electron beam evaporator. The thinnest gates are 30 nm wide and 30 nm apart. An additional thick gate metal layer was subsequently written and deposited and served to overcome the Mesa step and allow wire bonding of the sample without shorting gates together. Quantum dots were formed by means of depletion gates (as shown in Figure 3). The lower gates (LB, L, CB, R, RB) form a double quantum dot (DQD) system and the upper gates tune a charge sensor (CS) dot. The separation gates in the middle are tuned to maximize the CS sensitivity to charge transitions in the DQD. An LC-circuit connected to a CS ohmic contact allows fast read-out through microwave reflectometry. LB and RB are further connected to fast gate lines enabling fast control of the energy levels in the DQD.

Some arrangements of the disclosure are defined in the following numbered clauses.

1. A qubit device, comprising:

    a quantum well structure configured to host a hole gas in a quantum well; and
    a plurality of electrodes configured to allow the formation of a plurality of quantum dots in the hole gas and to allow encoding of a unit of quantum information in a plurality of hole spins hosted in the quantum dots.

2. The device of clause 1, wherein the unit of quantum information is encoded into singlet and triplet states of the hole spins hosted in the quantum dots.

3. The device of clause 1 or 2, wherein the plurality of quantum dots consists of a double quantum dot.

4. The device of any preceding clause, wherein the hole gas is a two-dimensional hole gas.

5. The device of clause 4, wherein the quantum well structure comprises a quantum well formed within a heterostructure of semiconductor layers.

6. The device of clause 4 or 5, wherein the quantum well is formed in a quantum well layer sandwiched between two confinement layers.

7. The device of clause 6, wherein the quantum well layer is a layer comprising more than 90% Ge.

8. The device of clause 7, wherein the Ge in the quantum well layer comprises isotopically purified Ge.

9. The device of any of clauses 6-8, wherein the thickness of the quantum well layer is in the range of 1-50nm.

10. The device of any of clauses 6-9, wherein either or both of the confinement layers comprises SiGe with a Si content in the range of 5-50% and a Ge content in the range of 95-50%.

11. The device of any of clauses 6-9, wherein either or both of the confinement layers comprises an oxide layer.

12. The device of any of clauses 6-11, wherein each of either or both of the confinement layers has a thickness in the range of 10-200nm.

13. The device of any of clauses 6-12, wherein the electrodes are formed on an oxide layer, the oxide layer being provided above an uppermost one of the confinement layers or forming the uppermost one of the confinement layers, wherein the oxide layer preferably has a thickness in the range of 5-50nm, further preferably comprising one or more of the following atomic layer deposition formed oxides: aluminium oxide, hafnium oxide, zirconium oxide.

14. The device of any preceding clause, configured to: implement X-rotations on the Bloch sphere of the qubit using a g-factor difference between hole spins and an applied magnetic field, wherein the applied magnetic field is preferably below 100mT; and/or to implement Z-rotations on the Bloch sphere of the qubit using the exchange interaction.

15. A method of operating a qubit device, comprising:

> providing the qubit device of any preceding clause; and
> using the plurality of electrodes to encode a unit of quantum information in a plurality of hole spins hosted in the quantum dots.

16. A method of operating a qubit device, comprising:

> providing a quantum well structure that hosts a hole gas in a quantum well;
> using a plurality of electrodes to form a plurality of quantum dots in the hole gas; and
> using the electrodes to encode a unit of quantum information in a plurality of hole spins hosted in the quantum dots.

17. The method of clause 16, wherein the unit of quantum information is encoded into singlet and triplet states of the hole spins hosted in the quantum dots.

18. The method of clause 16 or 17, wherein the plurality of quantum dots consists of a double quantum dot.

19. The method of any of clauses 16-18, wherein the hole gas is a two-dimensional hole gas.

20. The method of clause 19, wherein the quantum well structure comprises a quantum well formed within a heterostructure of semiconductor layers.

21. The method of clause 19 or 20, wherein the quantum well is formed in a quantum well layer sandwiched between two confinement layers.

22. The method of clause 21, wherein the quantum well layer is a layer comprising more than 90% Ge.

23. The method of clause 22, wherein the Ge in the quantum well layer comprises isotopically purified Ge.

24. The method of any of clauses 21-23, wherein a thickness of the quantum well layer is in the range of 1-50nm.

25. The method of any of clauses 21-24, wherein either or both of the confinement layers comprises SiGe with a Si content in the range of 5-50% and a Ge content in the range of 95-50%.

26. The method of any of clauses 21-25, wherein either or both of the confinement layers comprises an oxide layer.

27. The method of any of clauses 21-26, wherein each of either or both of the confinement layers has a thickness in the range of 10-200nm.

28. The method of any of clauses 21-27, wherein the electrodes are formed on an oxide layer, the oxide layer being provided above an uppermost one of the confinement layers or forming the uppermost one of the confinement layers, wherein the oxide layer preferably has a thickness in the range of 5-50nm, further preferably comprising one or more of the following atomic layer deposition formed oxides: aluminium oxide, hafnium oxide, zirconium oxide.

29. The method of any of clauses 16-28, wherein the encoding of the unit of quantum information includes implementing X-rotations on the Bloch sphere of the qubit using a g-factor difference between hole spins and an applied magnetic field, wherein the applied magnetic field is preferably below 100mT.

30. The method of any of clauses 16-29, wherein the encoding of the unit of quantum information includes implementing Z-rotations on the Bloch sphere of the qubit using the exchange interaction.

## Claims

1. A qubit device, comprising:

> a quantum well structure configured to host a hole gas in a quantum well; and
> a plurality of electrodes configured to allow the formation of a plurality of quantum dots in the hole gas and to allow encoding of a unit of quantum information in a plurality of hole spins hosted in the quantum dots.

2. The device of claim 1, wherein the unit of quantum information is encoded into singlet and triplet states of the hole spins hosted in the quantum dots.

3. The device of claim 1 or 2, wherein the plurality of quantum dots consists of a double quantum dot.

4. The device of any preceding claim, wherein the hole gas is a two-dimensional hole gas.

5. The device of claim 4, wherein the quantum well structure comprises a quantum well formed within a heterostructure of semiconductor layers.

6. The device of claim 4 or 5, wherein the quantum well is formed in a quantum well layer sandwiched between two confinement layers.

7. The device of claim 6, wherein the quantum well layer is a layer comprising more than 90% Ge.

8. The device of claim 7, wherein the Ge in the quantum well layer comprises isotopically purified Ge.

9. The device of any of claims 6-8, wherein the thickness of the quantum well layer is in the range of 1-50nm.

10. The device of any of claims 6-9, wherein either or both of the confinement layers comprises SiGe with a Si content in the range of 5-50% and a Ge content in the range of 95-50%.

11. The device of any of claims 6-9, wherein either or both of the confinement layers comprises an oxide layer.

12. The device of any of claims 6-11, wherein each of either or both of the confinement layers has a thickness in the range of 10-200nm.

13. The device of any of claims 6-12, wherein the electrodes are formed on an oxide layer, the oxide layer being provided above an uppermost one of the confinement layers or forming the uppermost one of the confinement layers, wherein the oxide layer preferably has a thickness in the range of 5-50nm, further preferably comprising one or more of the following atomic layer deposition formed oxides: aluminium oxide, hafnium oxide, zirconium oxide.

14. The device of any preceding claim, configured to:

    implement X-rotations on the Bloch sphere of the qubit using a g-factor difference between hole spins and an applied magnetic field, wherein the applied magnetic field is preferably below 100mT; and/or
    implement Z-rotations on the Bloch sphere of the qubit using the exchange interaction.

15. A method of operating a qubit device, comprising:

    providing the qubit device of any preceding claim; and
    using the plurality of electrodes to encode a unit of quantum information in a plurality of hole spins hosted in the quantum dots.

# Fig. 1

2

15

| 14 |
| 13 |
| 12 |
| 11 |
| W |

# Fig. 2

2

15

| 13 |
| 12 |
| 11 |
| W |

# Fig. 3

# Fig. 4

# Fig. 5

# Fig. 6

# Fig. 7

## Fig. 8

## Fig. 9

## Fig. 10

# Fig. 11

# Fig. 12

## Fig. 13

# Fig. 14

Fig. 15

Fig. 16

Fig. 17

Fig. 18

Fig. 19

# Fig. 20

# Fig. 21

## Fig. 22

## Fig. 23

# Fig. 24

$|S\rangle$

50

51

$|\downarrow\uparrow\rangle$

$|\uparrow\downarrow\rangle$

$|T_0\rangle$

# Fig. 25

Time

$\tau_s + \delta t$

$\tau_s$

$\varepsilon$

# Fig. 26

Time

$\tau_s + \delta t$

$2\tau_s$

$\tau_s$

$\varepsilon$

# Fig. 27

# Fig. 28

# Fig. 29

Europäisches
Patentamt

European
Patent Office

Office européen
des brevets

# EUROPEAN SEARCH REPORT

Application Number

EP 20 38 6054

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ANDREA HOFMANN ET AL: "Assessing the potential of Ge/SiGe quantum dots as hosts for singlet-triplet qubits", ARXIV.ORG, CORNELL UNIVERSITY LIBRARY, 201 OLIN LIBRARY CORNELL UNIVERSITY ITHACA, NY 14853, 13 October 2019 (2019-10-13), XP081514836, * figures 1, 2 * * page 3, section "Tunable double quantum dots", lines 1-8 * * page 10, section "Conclusion", lines 1-3 * * last paragraph of section "g-factor anitropy" on page 10 * | 1-15 | INV. G06N10/00 B82Y10/00 H01L29/06 H01L29/12 H01L29/423 H01L29/66 |
| X | HENDRICKX N W ET AL: "A four-qubit germanium quantum processor", ARXIV.ORG, CORNELL UNIVERSITY LIBRARY, 201 OLIN LIBRARY CORNELL UNIVERSITY ITHACA, NY 14853, 9 September 2020 (2020-09-09), XP081758937, * figures 1, 4 * * page 1, right column, second paragraph * | 1,15 | |
| A | SAMMAK A ET AL: "Low disordered, stable, and shallow germanium quantum wells: a playground for spin and hybrid quantum technology", ARXIV.ORG, CORNELL UNIVERSITY LIBRARY, 201 OLIN LIBRARY CORNELL UNIVERSITY ITHACA, NY 14853, 7 September 2018 (2018-09-07), XP081267802, DOI: 10.1002/ADFM.201807613 * figure 1 * * page 1, left column, second paragraph * | 8 | TECHNICAL FIELDS SEARCHED (IPC) G06N H01L B82Y |

The present search report has been drawn up for all claims

| Place of search | Date of completion of the search | Examiner |
|---|---|---|
| The Hague | 4 May 2021 | Theissing, Simon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)